# EUROPEAN PATENT SPECIFICATION

(11) **EP 2 725 082 B1**
(45) Date of publication and mention of the grant of the patent: **25.11.2015**
(21) Application number: 11868779.7
(22) Date of filing: 27.06.2011
(51) Int. Cl.: C09K 11/67, C23C 14/08, C23C 14/34, H05B 33/14

(54) **TITANIUM DOPED TERNARY SYSTEM SILICATE FILM, PREPARATION METHOD AND APPLICATION THEREOF**
SILIKATFILM AUS TITANDOTIERTEM TERNÄREM SYSTEM , VERFAHREN ZU SEINER HERSTELLUNG UND ANWENDUNG
FILM DE SILICATE À SYSTÈME TERNAIRE DOPÉ AU TITANE, PROCÉDÉ DE PRÉPARATION ET APPLICATION DE CELUI-CI

(43) Date of publication of application: 30.04.2014
(73) Proprietor: OCEAN'S KING LIGHTING SCIENCE & TECHNOLOGY CO., LTD., Guangdong 518054 (CN)
(72) Inventor: ZHOU, Mingjie, Shenzhen Guangdong 518054 (CN); WANG, Ping, Shenzhen Guangdong 518054 (CN); CHEN, Jixing, Shenzhen Guangdong 518054 (CN); ZHONG, Tietao, Shenzhen Guangdong 518054 (CN)
(74) Representative: Hubert, Philippe
(86) International application number: PCT/CN2011/076446
(87) International publication number: WO 2013/000111

(56) References cited:
- EP-A2- 0 680 244
- CN-A- 101 460 880
- CN-A- 101 978 781
- JP-A- 2001 234 161
- JP-A- 2001 234 162
- US-A- 3 494 779
- US-A- 5 688 438
- US-A1- 2003 227 007
- US-B1- 6 576 156

## Description

### TECHNICAL FIELD

The present invention relates to the field of semiconductor optoelectronic materials, in particular to a titanium doped ternary system silicate film and preparation method and application thereof

### BACKGROUND ART

Thin film electroluminescent displays (TFELD) due to its self-luminous, full-solid state structure, impact resistance, fast response, large viewing angle, wide applicable temperature, simple process, etc., has attracted wide attention, and thus has developed very rapidly. A monochromatic TFELD that employs ZnS: Mn as the light-emitting layer has been well-developed and thus commercialized. Currently, TFELD research is focused on the improvement of Blu-ray brightness for achieving multi-color and even full-color TFELD.

In luminescent system materials, in-depth study on rare earth doped silicate based phosphor powder has been conducted, in which good red to blue light excitation has been achieved. However, rare earth elements are expensive, and that silicate as used in the preparation of thin film electroluminescent materials often results in low film quality, poor performance, which limits further applications thereof.

### DISCLOSURE OF THE INVENTION

### Technical problems

The technical problem aimed to be solved by the present invention is to overcome the shortcomings in the prior art by providing a titanium doped ternary system silicate film and preparation method and application thereof.

Another object of the embodiment of the present invention is to provide a preparation method of the above-mentioned titanium doped ternary system silicate film.

Another object of the embodiment of the present invention is to provide a use of titanium doped ternary system silicate film in field emission devices, cathode-ray tubes and/or electroluminescent devices.

### Technical solution

The embodiment of the present invention is achieved in the following way: the first aspect provides a titanium doped ternary system silicate film, said titanium doped ternary system silicate film has the general formula of Ca₂₋ₓMgSi₂O₇: xTi⁴⁺, where x is from range of 0.00017∼0.0256.

The embodiment of the present invention is to provide a method for preparing the above-mentioned titanium doped ternary system silicate film, comprising the following steps:

mixing the CaO powder, MgO powder, SiO₂ powder and TiO₂ powder in a molar ratio of (2-x): 1: 2: x, sintering for forming the target, where x is from range of 0.00017-0.0256;

loading said target into a magnetron sputtering chamber; vacuum pumping; setting the operating pressure to 0.2 Pa-4 Pa; purging a mixed gas of inert gas and hydrogen, where the flow rate of said mixed gas is 15 sccm-35 sccm, the substrate temperature is 250°C∼750°C, sputtering power is 30 W-200 W; sputtering to afford a titanium doped ternary system silicate film.

### The beneficial effects

The use of a Ti-doped ternary system silicate in the titanium doped ternary system silicate film of the embodiment of the present invention results in a film that exhibits high luminescent intensity, high thermal stability and chemical stability. Said preparation method employs magnetron sputtering and has the advantages of high deposition rate, good film adhesion, easy to control and the achievement of large area deposition. Further, said film exhibits high stability, long lifetime as used in optoelectronic semiconductors.

### BRIEF DESCRIPTION OF THE DRAWING

Figure 1 shows the flowchart of the preparation method of the titanium doped ternary system silicate film of the embodiment according to the present invention.
Figure 2 shows schematically the structure of an electroluminescent device which employs the titanium doped ternary system silicate film of the embodiment according to the present invention as the emission layer.
Figure 3 shows the electroluminescence spectra of the titanium doped ternary system silicate film prepared by Example 1 according to the present invention.
Figure 4 shows the XRD patterns of the titanium doped ternary system silicate film prepared by Example 1 according to the present invention.

### DETAILED DESCRIPTION OF THE EMBODIMENTS

The above and other objects, features, and advantages of the present invention will become more apparent from the following detailed description when taken in conjunction with the accompanying drawings and embodiments. It should be understood that the specific embodiments described herein are merely for illustrative purpose, rather than limiting the present invention.

The embodiment of the present invention is achieved in the following way: the first aspect provides a titanium doped ternary system silicate film, said titanium doped ternary system silicate film has the general formula of Ca₂₋ₓMgSi₂O₇: xTi⁴⁺, where x is from range of 0.00017∼0.0256. Preferably, x is from range of 0.001~0.008.

Silicate host exhibits high chemical and thermal stability while high-purity raw material of silica is inexpensive and readily available, and thus are ideal host materials. As compared with rare earth elements, Ti is less expensive, even a small amount of it as doped in the host material Ca₂MgSi₂O₇ achieves high luminescent intensity.

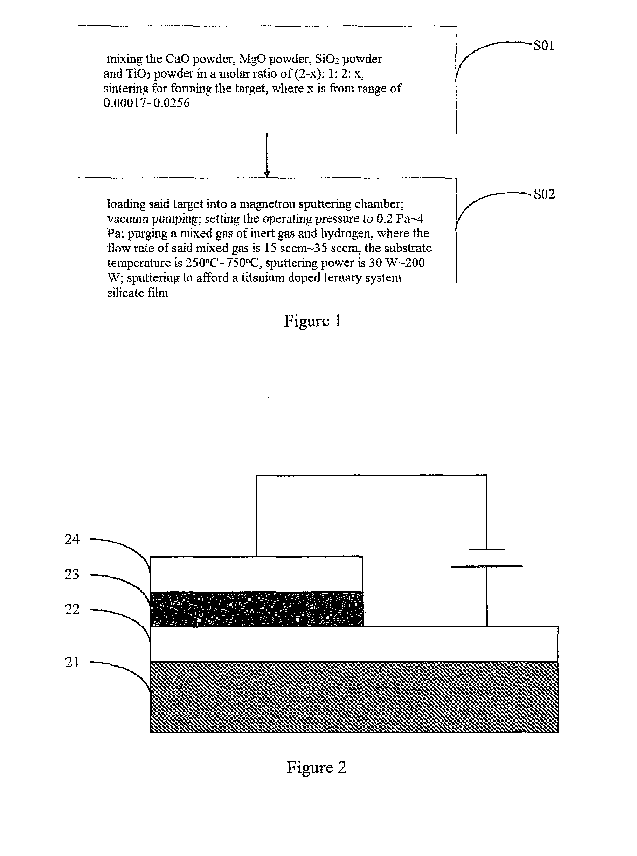

Another object of the embodiment of the present invention is to provide a preparation method of the titanium doped ternary system silicate film of the embodiment according to the present invention as shown in figure 1, comprising:

S01: mixing the CaO powder, MgO powder, SiO₂ powder and TiO₂ powder in a molar ratio of (2-x): 1: 2: x, sintering for forming the target, where x is from range of 0.00017-0.0256;

S02: loading said target into a magnetron sputtering chamber; vacuum pumping; setting the operating pressure to 0.2 Pa-4 Pa; purging a mixed gas of inert gas and hydrogen, where the flow rate of said mixed gas is 15 sccm-35 sccm, the substrate temperature is 250°C∼750°C, sputtering power is 30 W~200 W; sputtering to afford a titanium doped ternary system silicate film.

In step S01, CaO powder, MgO powder, SiO₂ powder and TiO₂ powder are weighed and mixed homogenously, sintering for forming the target. For example, sintering is conducted at a temperature from 900°C~1300°C, and results in the formation of a ceramic target of about Φ 50 × 2 mm. Preferably, the sintering temperature is 1250°C. The purity of the powder is preferably greater than 99.99%. The molar ratio of each component in the mixture is CaO: MgO: SiO₂: TiO₂ is (2-x): 1: 2: x, where × is from range of 0.00017~0.0256. The content of the matrix composition and the doping element is the major factor that affects the properties and structure of the film. Doping of metal ions affects the material structure, from which entry of foreign metal ions into the lattice renders the lattice structure some distortions. Therefore, excessive doping causes excessive lattice distortion, which disturbs the ion ordering in the lattice or leads to the generation of impurity phase in the material, and thus seriously weakens the material properties, while deficient doping results in degradation of the luminescent performance. Preferably, x is from range of 0.001 to 0.008.

In step S02, the substrate is a hard substrate like sapphire, quartz glass, silicon. Said substrate is subjected to ultrasonic washing with acetone, ethanol and deionized water before use. Also, a substrate may be further selected according to application, such as ITO glass substrate. The distance between the target and the substrate is preferably 45 mm~95 mm. More preferably, the distance between the target and the substrate is 60 mm. The target is loaded into the sputtering chamber, which the chamber is evacuated by means of a mechanical pump or a molecular pump such that a vacuum level of 1.0 × 10⁻³ Pa~1.0 × 10⁻⁵ Pa or more, preferably 6.0 × 10⁻⁴ Pa, is reached. For the sake of obtaining a titanium doped ternary system silicate film of high performance, setting of the process condition is very important. The operating gas in the sputtering chamber is a mixed gas of an inert gas and hydrogen, wherein the content in volume percentage of hydrogen is 1% to 15%, preferably 3% to 8%. Preferably, the flow rate of the mixed gas is 20 sccm~30 sccm, the operating pressure is 1.5 Pa~2.5 Pa, a substrate temperature is 400°C~600°C, a sputtering power is 100 W~140 W. Further, the thus-obtained titanium doped ternary system silicate film is then subjected to annealing, which results in the improvement of the film properties. The titanium doped ternary system silicate film obtained under the above-mentioned specific condition is subjected to annealing, which the annealing process comprises the process of heating the titanium doped ternary system silicate film to an annealing temperature, and the process of maintaining the temperature. Annealing temperature is 500°C~800°C. Preferably, the annealing temperature is 550°C~650°C, and the annealing environment may be an inert gas, such as nitrogen, argon, etc., or vacuum. In a preferred embodiment of the invention, the annealing process is conducted in a vacuum furnace at 0.01 Pa. The temperature for annealing cannot be elevated too rapidly or too slowly, the elevation rate is 1°C/min∼10°C/min, preferably, the elevation rate is 5°C/min∼8°C/min. The temperature is elevated to an annealing temperature, which the temperature is maintained for 1 h-3 h, preferably 2 h. Annealing improves the crystallization quality of the film and also improves the luminescence efficiency of the film.

The embodiment of the present invention also provides the use of above-mentioned titanium doped ternary system silicate film in field emission devices, cathode-ray tubes and/or electroluminescent devices. As exemplified by an electroluminescent device as shown in figure 2, where the electroluminescent device employs the titanium doped ternary system silicate film of the embodiment according to the present invention, and comprises sequentially laminated glass substrate 21, an anode 22, a light emitting layer 23, and a cathode 24. Anode 22 may employ indium tin oxide (abbreviated as ITO), light emitting layer 23 comprises a titanium doped ternary system silicate film of the embodiment according to the present invention; cathode 24 may be, but not limited to, metal Ag. Thus, in one particular embodiment, the thin-film electroluminescent device structure is expressed as: glass/ITO/Ti doped ternary system silicate film/Ag. Each layer can be prepared by conventional methods in the art, for example, an ITO coated glass substrate may be used, on which the above-mentioned titanium doped ternary system silicate film may be sputtered by magnetron sputtering, followed by deposition of an Ag layer.

The embodiment of the present invention provides a titanium doped ternary system silicate film, which the titanium doped ternary system silicate film thus obtained achieves high crystallinity just by doping with a small amount of titanium. The preparation method of said titanium doped ternary system silicate film employs magnetron sputtering, and achieves a film having high luminescent intensity, stable performance, while a good lifetime is also obtained. Moreover, subjecting the titanium doped ternary system silicate film to an annealing process by means of a mixed gas of inert gas and hydrogen after sputtering can improve the luminescence efficiency of the film, where a smaller amount of doping is sufficient to achieve an excellent film, which the film has a strong emission in the blue region.

Detailed description to the present invention will now be given with reference to the exemplary embodiments:

### Example 1:

CaO powder, MgO powder, SiO₂ powder and TiO₂ powder having a purity of 99.99% are mixed, the molar ratio of each component in the mixture CaO: MgO: SiO₂: TiO₂ is 1.994: 1: 2: 0.006, where the mass of CaO powder is 111.6 g, the mass of MgO powder is 40 g, the mass of SiO₂ powder is 120 g, the mass of TiO₂ powder is 0.48 g. After homogenous mixing, a ceramic target of Φ 50×2 mm is obtained by high-temperature sintering at 1250°C, the target is loaded into a vacuum chamber. An ITO coated glass substrate is then subjected to ultrasonic washing with a sequential use of acetone, anhydrous ethanol and deionized water, which is then subjected to oxygen plasma treatment, followed by placing it into the vacuum chamber. The distance between the target and the substrate is set to be 60 mm. The chamber is evacuated by means of a mechanical pump and molecular pump such that a vacuum level 5.0 × 10⁻⁵ Pa is reached, to which the vacuum chamber is purged with a mixed gas of argon gas and hydrogen, where the hydrogen content is 5% (in volume percentage), the gas flow rate is 25 sccm, the pressure is adjusted to 2.0 Pa, the substrate temperature is set to 500°C, the sputtering power is adjusted to 120 W, a titanium doped ternary system silicate film is obtained after sputtering. The thus-obtained titanium doped ternary system silicate film is subjected to annealing in a vacuum furnace at 0.01 Pa, where the annealing temperature is 600°C, the elevation rate is 6°C/min, the maintaining time is 2 h. The resulting film sample has a formula of Ca_{1.994}MgSi₂O₇: 0.006Ti⁴⁺.

### Example 2:

CaO powder, MgO powder, SiO₂ powder and TiO₂ powder having a purity of 99.99% are mixed, the molar ratio of each component in the mixture CaO: MgO: SiO₂: TiO₂ is 1.9997: 1: 2: 0.0003, where the mass of CaO powder is 111.98 g, the mass of MgO powder is 40 g, the mass of SiO₂ powder is 120 g, the mass of TiO₂ powder is 0.024 g. After homogenous mixing, a ceramic target of Φ 50×2 mm is obtained by high-temperature sintering at 900°C, the target is loaded into a vacuum chamber. A sapphire substrate is then subjected to ultrasonic washing with a sequential use of acetone, anhydrous ethanol and deionized water, and rinsed again with deionized water, and dried by high-temperature nitrogen blowing, and placed into the vacuum chamber. The distance between the target and the substrate is set to be 45 mm. The chamber is evacuated by means of a mechanical pump and molecular pump such that the vacuum level reaches 1.0 × 10⁻³ Pa, to which the vacuum chamber is purged with a mixed gas of argon and hydrogen, where the hydrogen content is 1% (in volume percentage), the gas flow rate is 10 sccm, the pressure is adjusted to 0.2 Pa, the substrate temperature is set to 250°C, the sputtering power is adjusted to 30 W, a titanium doped ternary system silicate film is obtained after sputtering. The thus-obtained titanium doped ternary system silicate film is subjected to annealing in a vacuum furnace at 0.01 Pa, where the annealing temperature is 500°C, the elevation rate is 10°C/min, the maintaining time is 1 h. The resulting film sample has a formula of Ca_{1.9997}MgSi₂O₇: 0.0003Ti⁴⁺.

### Example 3:

CaO powder, MgO powder, SiO₂ powder and TiO₂ powder having a purity of 99.99% are mixed, the molar ratio of each component in the mixture CaO: MgO: SiO₂: TiO₂ is 1.995: 1: 2: 0.005, where the mass of CaO powder is 111.72 g, the mass of MgO powder is 40 g, the mass of SiO₂ powder is 120 g, the mass of TiO₂ powder is 0.4 g. After homogenous mixing, a ceramic target of Φ 50×2 mm is obtained by high-temperature sintering at 1300°C, the target is loaded into a vacuum chamber. A sapphire substrate is then subjected to ultrasonic washing with a sequential use of acetone, anhydrous ethanol and deionized water, and rinsed again with deionized water, and dried by high-temperature nitrogen blowing, and placed into the vacuum chamber. The distance between the target and the substrate is set to be 95 mm. The chamber is evacuated by means of a mechanical pump and molecular pump such that a vacuum level 1.0 × 10⁻⁵ Pa is reached, to which the vacuum chamber is purged with a mixed gas of argon and hydrogen, where the hydrogen content is 1% (in volume percentage), the gas flow rate is 35 sccm, the pressure is adjusted to 4.0 Pa, the substrate temperature is set to 750°C, the sputtering power is adjusted to 200 W, a titanium doped ternary system silicate film is obtained after sputtering. The thus-obtained titanium doped ternary system silicate film is subjected to annealing in a vacuum furnace at 0.01 Pa, where the annealing temperature is 800°C, the elevation rate is 1°C/min, the maintaining time is 3 h. The resulting film sample has a formula of Ca_{1.95}MgSi₂O₇: 0.05Ti⁴⁺.

### Example 4:

CaO powder, MgO powder, SiO₂ powder and TiO₂ powder having a purity of 99.99% are mixed, the molar ratio of each component in the mixture CaO: MgO: SiO₂: TiO₂ is 1.99983: 1: 2: 0.00017, where the mass of CaO powder is 111.99 g, the mass of MgO powder is 40 g, the mass of SiO₂ powder is 120 g, the mass of TiO₂ powder is 0.0136 g. After homogenous mixing, a ceramic target of Φ 50×2 mm is obtained by high-temperature sintering at 1200°C, the target is loaded into a vacuum chamber. A sapphire substrate is then subjected to ultrasonic washing with a sequential use of acetone, anhydrous ethanol and deionized water, and rinsed again with deionized water, and dried by high-temperature nitrogen blowing, and placed into the vacuum chamber. The distance between the target and the substrate is set to be 50 mm. The chamber is evacuated by means of a mechanical pump and molecular pump such that a vacuum level 8.0 × 10⁻⁴ Pa is reached, to which the vacuum chamber is purged with a mixed gas of argon and hydrogen, where the hydrogen content is 3% (in volume percentage), the gas flow rate is 15 sccm, the pressure is adjusted to 2.5 Pa, the substrate temperature is set to 400°C, the sputtering power is adjusted to 100 W, a titanium doped ternary system silicate film is obtained after sputtering. The thus-obtained titanium doped ternary system silicate film is subjected to annealing under argon, where the annealing temperature is 650°C, the elevation rate is 4°C/min, the maintaining time is 2.5 h. The resulting film sample has a formula of Ca_{1.99983}MgSi₂O₇: 0.00017Ti⁴⁺.

### Example 5:

CaO powder, MgO powder, SiO₂ powder and TiO₂ powder having a purity of 99.99% are mixed, the molar ratio of each component in the mixture CaO: MgO: SiO₂: TiO₂ is 1.9744: 1: 2: 0.0256, where the mass of CaO powder is 110.57 g, the mass of MgO powder is 40 g, the mass of SiO₂ powder is 120 g, the mass of TiO₂ powder is 2.048 g. After homogenous mixing, a ceramic target of Φ 50×2 mm is obtained by high-temperature sintering at 1200°C, the target is loaded into a vacuum chamber. A sapphire substrate is then subjected to ultrasonic washing with a sequential use of acetone, anhydrous ethanol and deionized water, and rinsed again with deionized water, and dried by high-temperature nitrogen blowing, and placed into the vacuum chamber. The distance between the target and the substrate is set to be 70 mm. The chamber is evacuated by means of a mechanical pump and molecular pump such that a vacuum level 7.0 × 10⁻⁴ Pa is reached, to which the vacuum chamber is purged with a mixed gas of argon and hydrogen, where the hydrogen content is 8% (in volume percentage), the gas flow rate is 30 sccm, the pressure is adjusted to 1.5 Pa, the substrate temperature is set to 600°C, the sputtering power is adjusted to 140 W, a titanium doped ternary system silicate film is obtained after sputtering. The thus-obtained titanium doped ternary system silicate film is subjected to annealing under argon, where the annealing temperature is 550°C, the elevation rate is 8°C/min, the maintaining time is 1.5 h. The resulting film sample has a formula of Ca_{1.9744}MgSi₂O₇: 0.0256Ti⁴⁺.

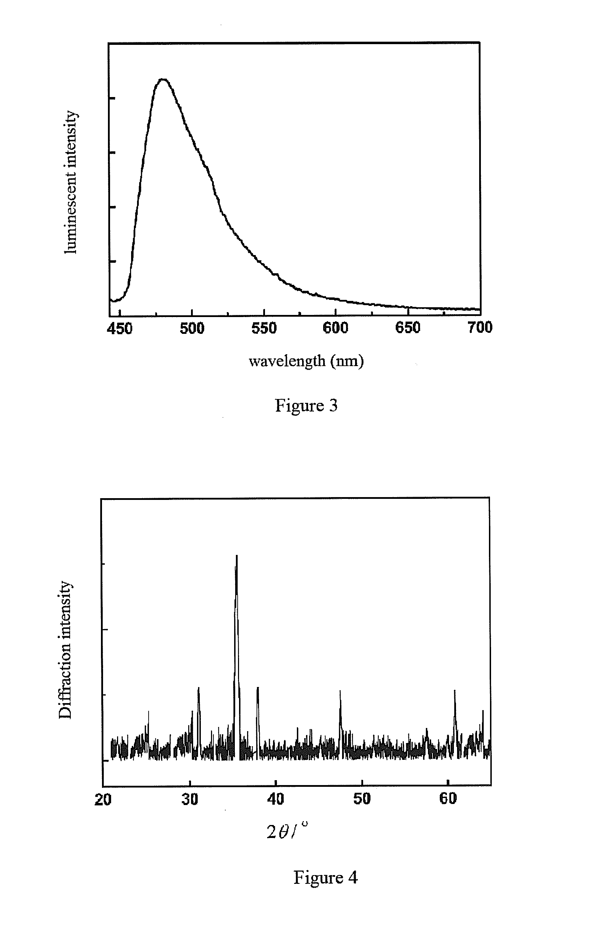

Figure 3 shows the electroluminescence spectra of the titanium doped ternary system silicate film prepared by Example 1 according to the present invention, it has a strong blue emission peak at 480 nm, indicating that the titanium doped ternary system silicate is a blue material having good performance.

Figure 4 shows the XRD patterns of the titanium doped ternary system silicate film prepared by Example 1 according to the present invention. As compared with standards and JCPDS standard card, characteristic peaks in the spectra are crystallization peaks of the silicate host, diffraction peaks are not found for the doping elements and other impurities.

Although the present invention has been described and illustrated in detail, it is clearly understood that the same is by way of illustrating the preferred embodiment of the present invention and is not to be taken by way of limitation, it should be understood that various changes, substitutions, and alterations could be made hereto without departing from the scope of the invention.

## Claims

1. A titanium doped ternary system silicate film, **characterized in that** said titanium doped ternary system silicate film has the general formula of Ca₂₋ₓMgSi₂O₇: xTi⁴⁺, where x is from range of 0.00017∼0.0256.

2. A titanium doped ternary system silicate film according to claim 1, **characterized in that** x is from range of 0.001∼0.008.

3. A method of preparing a titanium doped ternary system silicate film, **characterized in that** said method comprises the steps of: mixing the CaO powder, MgO powder, SiO₂ powder and TiO₂ powder in a molar ratio of (2-x): 1: 2: x, sintering for forming the target, where x is from range of 0.00017-0.0256; loading said target into a magnetron sputtering chamber; vacuum pumping; setting the operating pressure to 0.2 Pa~4 Pa; purging a mixed gas of inert gas and hydrogen, where the flow rate of said mixed gas is 15 sccm-35 sccm, the substrate temperature is 250°C∼750°C, sputtering power is 30 W-200 W; sputtering to afford a titanium doped ternary system silicate film.

4. A method of preparing a titanium doped ternary system silicate film according to claim 3, **characterized in that** said method further comprises subjecting the resulting titanium doped ternary system silicate film to annealing.

5. A method of preparing a titanium doped ternary system silicate film according to claim 4, **characterized in that** said annealing is conducted at a annealing temperature of 500°C∼800°C and the maintaining time for said annealing is 1h~3 h.

6. A method of preparing a titanium doped ternary system silicate film according to claim 3, **characterized in that** x is from range of 0.001∼0.008.

7. A method of preparing a titanium doped ternary system silicate film according to claim 3, **characterized in that** the content in volume percentage of hydrogen in said mixed gas is 1%∼ 15%.

8. A method of preparing a titanium doped ternary system silicate film according to claim 3, **characterized in that** the content in volume percentage of hydrogen in said mixed gas is 3%~ 8%.

9. A method of preparing a titanium doped ternary system silicate film according to any one of claims 3 to 8, **characterized in that** said operating pressure in said chamber is 1.5 Pa~2.5 Pa, said substrate temperature is 400°C~600°C, said sputtering power is 100 W~140 W.

10. A use of a titanium doped ternary system silicate film according to claim 1 or 2 in field emission devices, cathode-ray tubes and/or electroluminescent devices.

## Patentansprüche

1. Titan-dotierter Ternärsystem-Silikatfilm, **dadurch gekennzeichnet, dass** der Titan-dotierte Ternärsystem-Silikatfilm die allgemeine Formel Ca₂₋ₓMgSi₂O₇:xTi⁴⁺, aufweist, wobei x im Bereich von 0,00017 bis 0,0256 liegt.

2. Titan-dotierter Ternärsystem-Silikatfilm nach Anspruch 1, **dadurch gekennzeichnet, dass** x im Bereich von 0,001 bis 0,008 liegt.

3. Verfahren zum Herstellen eines Titan-dotierten Ternärsystem-Silikatfilms, **dadurch gekennzeichnet, dass** das Verfahren die Schritte umfasst: Mischen des CaO-Pulvers, MgO-Pulvers, SiO₂-Pulvers und TiO₂-Pulvers in einem Molverhältnis von (2-x): 1: 2: x, Sintern zum Ausbilden des Targets, wobei x im Bereich von 0,00017 bis 0,0256 liegt, Laden des Targets in eine Magnetron-Sputter-Kammer, Vakuumpumpen, Einstellen des Betriebsdrucks auf 0,2 Pa bis 4 Pa, Einspülen eines Mischgases aus einem inerten Gas und Wasserstoff, wobei die Flowrate des Mischgases 15 sccm bis 35 sccm beträgt, die Substrattemperatur 250 °C bis 750 °C beträgt, die Sputterleistung 30 W bis 200 W beträgt, Sputtern, um einen Titan-dotierten Ternärsystem-Silikatfilm zu erhalten.

4. Verfahren zum Herstellen eines Titan-dotierten Ternärsystem-Silikatfilms nach Anspruch 3, **dadurch gekennzeichnet, dass** das Verfahren ferner umfasst:
Unterziehen des erhaltenen Titan-dotierten Ternärsystem-Silikatfilms einem Annealing.

5. Verfahren zum Herstellen eines Titan-dotierten Ternärsystem-Silikatfilms nach Anspruch 4, **dadurch gekennzeichnet, dass** das Annealing bei einer Annealingtemperatur von 500 °C bis 800 °C durchgeführt wird und die Beibehaltungszeit für das Annealing 1 - 3 h beträgt.

6. Verfahren zum Herstellen eines Titan-dotierten Ternärsystem-Silikatfilms nach Anspruch 3, **dadurch gekennzeichnet, dass** x im Bereich von 0,001 bis 0,008 liegt.

7. Verfahren zum Herstellen eines Titan-dotierten Ternärsystem-Silikatfilms nach Anspruch 3, **dadurch gekennzeichnet, dass** der Wasserstoff-Gehalt in Vol.-% in dem Mischgas 1 % bis 15 % beträgt.

8. Verfahren zum Herstellen eines Titan-dotierten Ternärsystem-Silikatfilms nach Anspruch 3, **dadurch gekennzeichnet, dass** der Wasserstoff-Gehalt in Vol.-% in dem Mischgas 3 % bis 8 % beträgt.

9. Verfahren zum Herstellen eines Titan-dotierten Ternärsystem-Silikatfilms nach einem der Ansprüche 3 bis 8, **dadurch gekennzeichnet, dass** der Betriebsdruck in der Kammer 1,5 Pa bis 2,5 Pa beträgt, die Substrattemperatur 400 °C bis 600 °C beträgt, die Sputterleistung 100 W bis 140 W beträgt.

10. Verwendung eines Titan-dotierten Ternärsystem-Silikatfilms nach Anspruch 1 oder 2 bei Feldemissionsvorrichtungen, Kathodenstrahlröhren und/oder Elektrolumineszenz-Vorrichtungen.

## Revendications

1. Film de silicate à système ternaire dopé au titane, **caractérisé en ce que** ledit film de silicate à système ternaire dopé au titane présente la formule générale de Ca₂₋ₓMgSi₂O₇:xTi⁴⁺, où x se trouve dans l'intervalle de 0,00017 ~ 0,0256.

2. Film de silicate à système ternaire dopé au titane selon la revendication 1, **caractérisé en ce que** x se trouve dans l'intervalle de 0,001 ~ 0,008.

3. Procédé de préparation d'un film de silicate à système ternaire dopé au titane, **caractérisé en ce que** ledit procédé comprend les étapes de : mélange des poudre de CaO, poudre de MgO, poudre de SiO₂ et poudre de TiO₂ dans un rapport molaire de (2-x):1:2:x, frittage pour former la cible, où x se trouve dans l'intervalle de 0,00017 ~ 0,0256 ; charge de ladite cible dans une chambre de pulvérisation magnétron ; pompage sous vide ; ajustement de la pression de fonctionnement à 0,2 Pa ~ 4 Pa ; purge d'un gaz mixte de gaz inerte et d'hydrogène, dans lequel le débit dudit gaz mixte est de 15 sccm ~ 35 sccm, la température du substrat est de 250°C ~ 750°C, la puissance de pulvérisation est de 30 W ~ 200 W ; pulvérisation pour réaliser un film de silicate à système ternaire dopé au titane.

4. Procédé de préparation d'un film de silicate à système ternaire dopé au titane selon la revendication 3, **caractérisé en ce que** ledit procédé consiste de plus à soumettre le film de silicate à système ternaire dopé au titane résultant à un recuit.

5. Procédé de préparation d'un film de silicate à système ternaire dopé au titane selon la revendication 4, **caractérisé en ce que** ledit recuit est réalisé à une température de recuit de 500°C ~ 800°C et la durée de maintien pour ledit recuit est de 1 h ~ 3 h.

6. Procédé de préparation d'un film de silicate à système ternaire dopé au titane selon la revendication 3, **caractérisé en ce que** x se trouve dans l'intervalle de 0,001 ~ 0,008.

7. Procédé de préparation d'un film de silicate à système ternaire dopé au titane selon la revendication 3, **caractérisé en ce que** la teneur en pourcentage volumique de l'hydrogène dans ledit gaz mixte est de 1 % ~ 15 %.

8. Procédé de préparation d'un film de silicate à système ternaire dopé au titane selon la revendication 3, **caractérisé en ce que** la teneur en pourcentage volumique de l'hydrogène dans ledit gaz mixte est de 3 % ~ 8 %.

9. Procédé de préparation d'un film de silicate à système ternaire dopé au titane selon l'une quelconque des revendications 3 à 8, **caractérisé en ce que** ladite pression de fonctionnement dans ladite chambre est de 1,5 Pa ~ 2,5 Pa, ladite température de substrat est de 400°C ~ 600°C, ladite puissance de pulvérisation est de 100 W ~ 140 W.

10. Utilisation d'un film de silicate à système ternaire dopé au titane selon la revendication 1 ou 2 dans des dispositifs d'émission de champ, des tubes à rayons cathodiques et/ou des dispositifs électroluminescents.
